# EUROPEAN PATENT SPECIFICATION

(11) **EP 3 254 833 B1**
(45) Date of publication and mention of the grant of the patent: **15.06.2022**
(21) Application number: 15881092.9
(22) Date of filing: 05.02.2015
(51) Int. Cl.: B29C 67/00

(54) **ADDITIVE MANUFACTURING SYSTEM**
SYSTEM ZUR GENERATIVEN FERTIGUNG
SYSTÈME DE FABRICATION ADDITIVE

(43) Date of publication of application: 13.12.2017
(73) Proprietor: FUJI Corporation, Chiryu Aichi (JP)
(72) Inventor: FUJITA, Masatoshi, Chiryu Aichi (JP); KODAMA, Seigo, Chiryu Aichi (JP); TSUKADA, Kenji, Chiryu Aichi (JP); KAWAJIRI, Akihiro, Chiryu Aichi (JP)
(74) Representative: Grünecker Patent- und Rechtsanwälte PartG mbB
(86) International application number: PCT/JP2015/053187
(87) International publication number: WO 2016/125275

(56) References cited:
- EP-A1- 1 204 527
- WO-A1-2005/057436
- WO-A1-2013/010108
- JP-A- 2005 503 939
- JP-A- 2014 527 474
- US-A1- 2005 038 549
- US-A1- 2013 124 151
- Anonymous: "Integrated circuit design - Wikipedia", , 18 January 2015 (2015-01-18), XP055419021, Retrieved from the Internet: URL:https://en.wikipedia.org/w/index.php?t itle=Integrated_circuit_design&oldid=64298 9653 [retrieved on 2017-10-25]

## Description

### Technical Field

The present invention relates to a data conversion device which converts three-dimensional data of an electrical device such as a multilayer wiring board onto which an electronic component is mounted into data which can be used in shaping by an additive manufacturing, and an additive manufacturing system which performs shaping using the additive manufacturing based on the post-conversion data.

### Background Art

In the related art, in manufacturing facilities for manufacturing multilayer wiring boards onto which an electronic component and the like are mounted, the manufacturing conditions such as the material and shape of the multilayer wiring board are fixed due to the necessity of mass production and the like, and in a case in which small, three-dimensional boards such as those demanded of wearable devices and the like in recent years are manufactured, there is a case in which restrictions are imposed by the manufacturing conditions. A manufacturing process of the multilayer wiring board includes various processes such as a process of printing a wiring, a process of opening holes for pillars, a process of layering an insulating layer, and a process of mounting an electronic component and the like. Since the order of the multiple manufacturing processes greatly influences the manufacturing period, the manufacturing cost, and the like, it is not easy to customize the processes individually or the like. Therefore, it is difficult to manufacture a multilayer wiring board or the like which has rich customizability according to the demands of a user in a short period.

To handle this, realizing a three-dimensional shape which is designed using CAD (Computer Aided Design) using a rapid prototyping (Rapid Prototyping) system is practiced in various fields. In particular, in a rapid prototyping system which is used in the additive manufacturing, it is possible to manufacture a three-dimensional shaped article which is small and has rich customizability while having a simple device configuration. For the additive manufacturing, laser beam lithography (SL: Stereo Lithography), a powder sintering method (SLS: Selective Laser Sintering), fused deposition molding (FDM: Fused Deposition Molding), and the like are known. For example, in a manufacturing apparatus which is disclosed in PTL 1, a designer uses a computer system which executes a three-dimensional CAD program to design a desired three-dimensional shaped article. The desired three-dimensional shaped article is layer-shaped using layer data of a cross-sectional shape which is obtained by slicing data of the designed three-dimensional shaped article.

PTL 1: JP-A-2011-241450

WO 2013/010108 relates to the fabrication of complicated electronic and/or mechanical structures and devices and components using homogeneous or heterogeneous 3D additive build processes. In particular it relates to selective metallization processes including electroless and/or electrolytic metallization.

### Summary of Invention

### Technical Problem

However, in the patent literature which is described above, the manner in which the layer data which is used in the additive manufacturing is created from the CAD data is not disclosed. For example, in the multilayer wiring board, an insulating layer which is formed of a resin material, a wiring pattern which is formed of a metal material, and the like are included in the same layer, and it is difficult to obtain the desired layer data by just simply dividing three-dimensional data such as the CAD data into each layer.

The present invention is made in consideration of the problems described above, and an object is to provide an additive manufacturing system including a data conversion device which is capable of generating data which is necessary for manufacturing an electrical device from three-dimensional data using an additive manufacturing.

### Solution to Problem

The present invention is defined by the subject-matter of the appended claims. Further features of the present invention will become apparent from the following description of exemplary embodiments with reference to the attached drawings.

In order to solve the problems described above, a additive manufacturing system according to Claim 1 of the present application is configured to shape an electrical device using an additive manufacturing based on data which is configured to be converted by a data conversion device, said data being three-dimensional data of the electrical device, comprising the shape, material and position of members with which the electronic device is provided, wherein the additive manufacturing system comprises at least one of a plurality of units to for shaping the members including units of a stage unit which is configured to move with a layered workpiece which is shaped being placed on a stage, a discharge unit which is configured to discharge either a conductive material or an insulating material onto the stage to shape a layered workpiece, a firing unit which is configured to fire the conductive material which is discharged onto the stage by the discharge unit to shape a wiring pattern, a curing unit which is configured to cure the insulating material which is discharged onto the stage by the discharge unit to shape an insulating layer, and a mounting unit which is configured to mount an electronic component onto the layered workpiece. And the data conversion device includes a layer information generation section which, with respect to three-dimensional data of an electrical device, detects members which are included in the three-dimensional data and generates layer information for each of the detected members, a layer data division section which generates layer data in which the members which are included in the layer information are divided into layer thicknesses which can be shaped using materials using an additive manufacturing based on information of the materials of the members which are included in the three-dimensional data, a unit determination section which determines a unit among said units for shaping the members based on the layer data, and a control content determination section which generates control data for operating the unit which is determined by the unit determination section according to a shape of the layer data, wherein the detected members include a wiring pattern and/or an insulating layer. The electrical device referred to here includes, for example, various devices which are provided with an electronic component such as a multilayer wiring board onto which an electronic component is mounted, electrical equipment in which an electronic component such as a connector is embedded, or alternatively, so-called wearable devices in which an electronic component is embedded in eyeglasses or the like that a person wears on the body, or the like.

In the additive manufacturing system according to Claim 2, the data conversion device in the additive manufacturing system according to Claim 1 further includes a first correction section which determines whether or not the members can be shaped using an additive manufacturing based on thickness or curvature of the members which are included in the three-dimensional data, and in a case in which the members cannot be shaped, corrects the members to a shape which can be shaped.

In the additive manufacturing system according to Claim 3, the data conversion device in the additive manufacturing system according to Claim 1 or 2 further includes a second correction section which calculates electrical characteristics of the electrical device based on the three-dimensional data and corrects the three-dimensional data so as to improve the electrical characteristics based on a result of the calculation by changing the shape or position the wiring pattern or insulating layer.

In the additive manufacturing system according to Claim 4, the data conversion device in the additive manufacturing system according to any of Claims 1 to 3 further includes a support material shaping determination section which detects an external shape of the electrical device based on the three-dimensional data and determines whether or not it is necessary to shape a support material which conforms to the external shape of the electrical device.

### Advantageous Effects of Invention

In the additive manufacturing system according to Claim 1 of the present application, the layer information generation section detects members which are included in the three-dimensional data and generates layer information for each of the detected members with respect to the three-dimensional data of the electrical device. For example, the layer information generation section generates data such as shapes and positions for each of the members such as the wiring pattern, the insulating layer, and the pillars with which the electrical device (for example, a multilayer wiring board) is provided as layer information from the three-dimensional data. The layer data division section generates the layer data in which the members which are included in the layer information are divided into layer thicknesses which can be shaped using the materials by the additive manufacturing based on the information of the materials of the members which are included in the three-dimensional data. For example, in a case in which the insulating layer of the multilayer wiring board is shaped by discharging droplets of an insulating material using the inkjet method, the layer thickness which can be shaped at one time is determined according to the size of the droplets of the insulating material which is used. Therefore, the layer data division section divides the layer information into the layer data according to the maximum layer thickness which can be shaped, for example. The unit determination section performs a process of associating a unit which shapes the member based on the layer data, for example, the discharge unit which discharges the insulating material as the unit which performs the shaping with respect to the layer information of the insulating layer and the layer data. The control content determination section generates control data for operating the unit which is determined by the unit determination section according to the shape of the layer data.

In the additive manufacturing system, for example, it is possible to generate the control data and the like necessary for controlling a unit included in a manufacturing apparatus that performs the shaping using the additive manufacturing based on the three-dimensional data of the electrical device. Therefore, the user becomes capable of acquiring the necessary data for the layered shaping merely by setting the three-dimensional data of the electrical device and inputting the three-dimensional data to the data conversion device. It becomes possible to obtain a reduction in the number of workers necessary in the manufacturing process of the electrical device and a shortening of the time necessary for the manufacturing. As the additive manufacturing referred to here, for example, it is possible to apply stereo lithography, selective laser sintering, fused deposition molding, a UV curing inkjet method, an inkjet binder method, and the like. More specifically, examples of the method include a method of laying a powder of a metal or a resin in a layered shape and sintering the powder with a laser, a method of adding a binder (a bonding material) to perform fixing, a method of discharging a UV curable resin using the inkjet method and subsequently irradiating the UV curable resin with an ultraviolet ray to cure the UV curable resin, a method of melting a thermally plastic resin at high temperature to deposit the resin, and the like.

In the additive manufacturing system according to Claim 2 of the present application, the first correction section determines whether or not it is possible to shape the members which are included in the electrical device using the additive manufacturing, and in a case in which it is not possible to perform the manufacturing, corrects the members to shapes which can be shaped. For example, even in data which is drawn as curves in the three-dimensional data, in a case in which the lines are extremely fine, even if the droplets are discharged using the inkjet method to perform the shaping, there is a concern that the distance between adjacent droplets is separated and the curve does not connect due to limits in the accuracy of the discharge position and the like. In a case in which curves are used for the wiring pattern, there is a concern that the shaped electrical device will become unable to realize the desired function due to causes such as electrical connection faults due to an open circuit. In such a case, in a case in which the line thickness, the curvature, or the like which are defined in the three-dimensional data do not satisfy predetermined conditions, the first correction section is capable of preemptively preventing connection faults and the like by automatically changing the shape to one that can be shaped.

For example, in a case in which the pillars which connect the wiring patterns of each of the layers to each other are inclined with respect to the vertical direction of the boards plane of the circuit board, there is a concern that the shaping will become difficult. For example, in a manufacturing method in which after shaping a planar insulating layer once using the insulating material, holes which are necessary for the shaping of the pillars are opened in the insulating layer using laser irradiation, because the control of the irradiation direction of the laser becomes complicated or the accuracy of the shape of the holes to be formed cannot be secured, it is preferable to irradiate the upper face of the insulating layer with the laser from the vertical direction and open the holes. In other words, it is preferable that the pillars not be inclined in order to obtain simplification of the manufacturing process or the like. Therefore, in a case in which pillars of an inclined shape are included in the three-dimensional data, the first correction section performs a process of correcting the inclination of the pillars, correcting the positions of the wiring pattern accordingly, and the like, and changes the shape to one that can be manufactured. Accordingly, since the possibility of the manufacturing is determined and the three-dimensional data is corrected with respect to the electrical device for which the three-dimensional data is created, it is possible to reduce the returning to the design process and to shorten the period which is necessary for the performance of all processes.

In the additive manufacturing system according to Claim 3, the second correction section calculates electrical characteristics of the electrical device and corrects the three-dimensional data so as to improve the electrical characteristics based on a result of the calculation. The electrical characteristics referred to here are, for example, characteristics which are determined according to the shapes of the wiring pattern and the insulating layer, the position of the electronic component to be mounted, and the like. For example, in a case in which the routing of the wiring pattern which connects across the electronic component is not the shortest distance, the second correction section corrects the shape and position of the wiring pattern, the position of the electronic component, and the like. Accordingly, it is possible to shorten the wiring pattern to reduce the resistance (electrical loss), to reduce the influence of noise from outside, or the like. In a case in which the thickness of the wiring pattern is not set to a thickness in a range which is necessary for transmitting an electrical signal, the second correction section performs correction of the thickness to ensure that the signal is correctly transmitted. For example, the second correction section determines whether it is possible for the electronic component to operate within a permitted operation temperature range based on the quantity of heat which is generated from the electronic component to be mounted, the shapes of the wiring pattern which connects the electronic component and the insulating layer which surrounds the electronic component, and the like. In other words, the second correction section may determine the possibility of the heat design of the electrical device. In a case in which it is necessary to make changes to the heat design, the second correction section changes the position of the electronic component, the shape of the insulating layer, and the like. Accordingly, even if the three-dimensional data is designed by a user with insufficient technical skill to design the electronic circuit and the like, it is possible to correct the three-dimensional data to that which satisfies desired electrical characteristics using the data conversion device. In other words, it is possible to widen the target range of designers.

In the additive manufacturing system according to Claim 4 of the present application, the support material shaping determination section determines whether or not it is necessary to shape the support material which conforms to the external shape of the electrical device. The support material which is referred to here is, for example, a shape which is used for shaping an electrical device of a desired shape and is removed after the electrical device is shaped. The method of removing the support material is, for example, a method of cutting, a method of melting using heat, a method of using a specific liquid such as water or a chemical to perform melting, or the like. For example, in a case in which the electrical device has a shape which is provided with a part which protrudes toward the outside, is a shape in which the bottom section is rounded, or the like, it is difficult to simply stack and shape from the bottom layer. In this case, a necessary part is shaped inside the shape of the support material, and a method of removing the support material later becomes necessary. Therefore, the support material shaping determination section detects the external shape of the electrical device based on the three-dimensional data and determines whether or not it is necessary to shape the support material. Accordingly, it is possible to automatically determine whether or not it is necessary to add a process of shaping the support material or the like based on the three-dimensional data of the electrical device.

### Brief Description of Drawings

[Fig. 1] Fig. 1 is a diagram illustrating a configuration of an additive manufacturing system of a present example.
[Fig. 2] Fig. 2 is a block diagram illustrating a configuration of a data conversion device.
[Fig. 3] Fig. 3 is a schematic diagram illustrating a configuration of an electronic device manufacturing apparatus.
[Fig. 4] Fig. 4 is a block diagram illustrating the configuration of the electronic device manufacturing apparatus.
[Fig. 5] Fig. 5 is a flowchart illustrating a process of automatic manufacturing of an electronic device by the additive manufacturing system.
[Fig. 6] Fig. 6 is a schematic diagram for describing a manufacturing process of the electronic device.
[Fig. 7] Fig. 7 is a schematic diagram for describing the manufacturing process of the electronic device.
[Fig. 8] Fig. 8 is a schematic diagram for describing the manufacturing process of the electronic device.
[Fig. 9] Fig. 9 is a schematic diagram for describing the manufacturing process of the electronic device.
[Fig. 10] Fig. 10 is a schematic diagram for describing the manufacturing process of the electronic device.
[Fig. 11] Fig. 11 is a schematic diagram for describing the manufacturing process of the electronic device.
[Fig. 12] Fig. 12 is a schematic diagram for describing the manufacturing process of the electronic device.
[Fig. 13] Fig. 13 is a schematic diagram for describing the manufacturing process of the electronic device.
[Fig. 14] Fig. 14 is a diagram for describing the structure of the electronic device for which support material is necessary during the shaping.

### Description of Embodiments

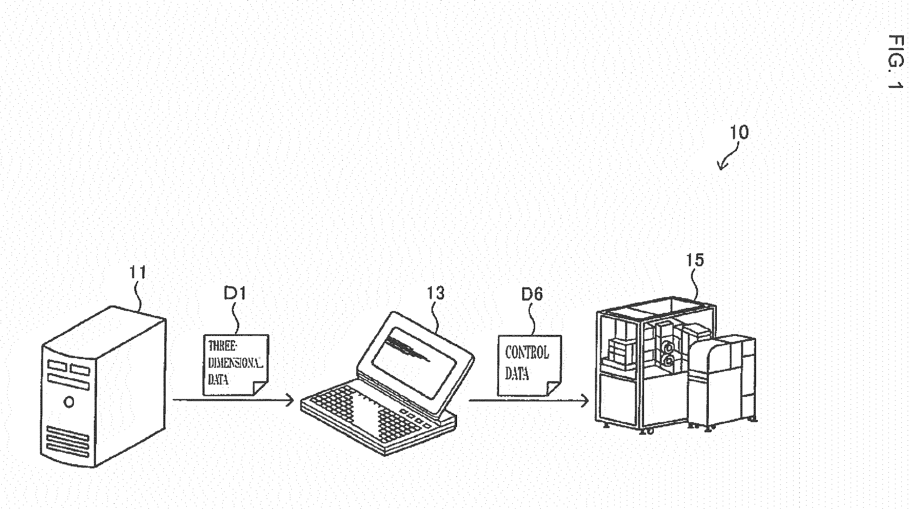

Hereinafter, an example of an additive manufacturing system of the present invention will be described with reference to the drawings. Fig. 1 illustrates the configuration of an additive manufacturing system (hereinafter this may be shortened to "system") 10 of the present example. The system 10 is provided with a server 11, a data conversion device 13, and an electronic device manufacturing apparatus (hereinafter this may be shortened to "manufacturing apparatus") 15. The system 10 is a system in which three-dimensional data D1 which is stored in the server 11 is converted using the data conversion device 13 and a manufacturing apparatus 15 manufactures an electronic device using the additive manufacturing based on post-conversion control data D6.

Data which is designed using CAD (Computer Aided Design), for example, is saved in the server 11 as the three-dimensional data D1 of the electronic device which is shaped by the manufacturing apparatus 15. In the three-dimensional data D1, for example, in addition to drawing data such as the shape and position of the members (the wiring pattern and the like) with which the electronic device is provided, data relating to the materials such as which material each of the members is formed of is defined. The server 11 transmits the saved three-dimensional data D1 to the data conversion device 13 in response to a request from the data conversion device 13. The input source of the three-dimensional data D1 which is used in the conversion by the data conversion device 13 is not particularly limited. For example, in the data conversion device 13, other than from the server 11, the three-dimensional data D1 may be received from another personal computer, and the three-dimensional data D1 may be input from an external memory medium such as USB memory, a CD, or a DVD. Alternatively, the data conversion device 13 may use an input device such as a keyboard with which the data conversion device 13 is provided to convert the three-dimensional data D1 which is designed by the user.

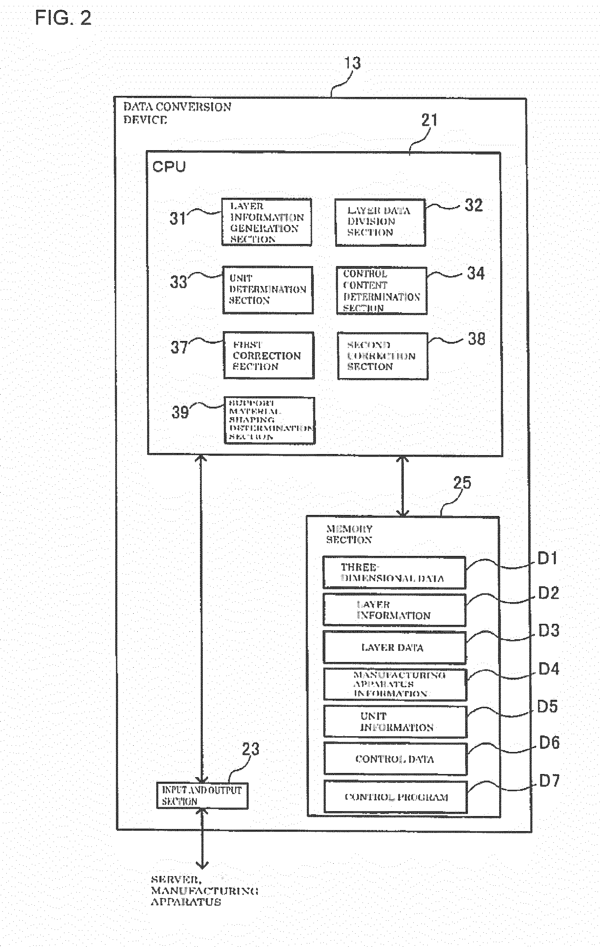

Next, description will be given of the data conversion device 13. As illustrated in Fig. 2, the data conversion device 13 is a personal computer, the main constituent of which is a CPU (Central Processing Unit) 21, and is provided with an input and output section 23, a memory section 25, and the like. The input and output section 23 is connected to the server 11 and inputs the three-dimensional data D1 from the server 11. The CPU 21 temporarily saves the three-dimensional data D1 which is input by the input and output section 23 in the memory section 25. The memory section 25 is provided with a memory, a hard disk, and the like, and in addition to the three-dimensional data D1, a control program D7 which is executed on the CPU 21 and the like are saved in the memory section 25.

By reading and executing the control program D7 which is stored in the memory section 25, the CPU 21 realizes various processing modules such as a layer information generation section 31, a layer data division section 32, a unit determination section 33, a control content determination section 34, a first correction section 37, a second correction section 38, and a support material shaping determination section 39. In the present example, the layer information generation section 31 and the like are configured as software which is realized by the control program D7 being executed by the CPU 21; however, the layer information generation section 31 and the like may be configured as dedicated hardware.

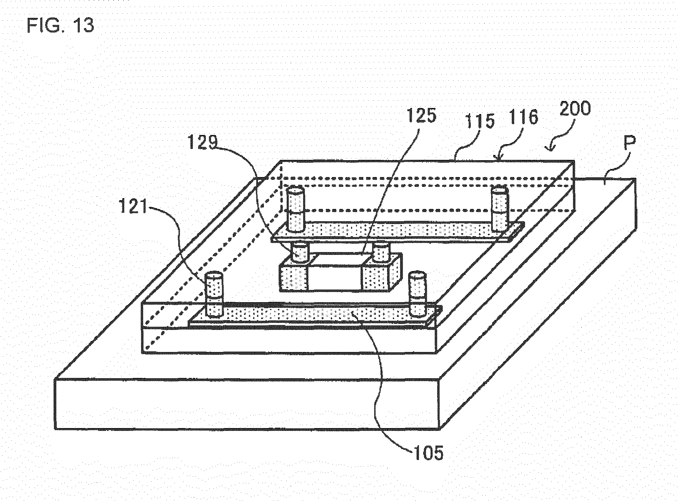

In the following description, as an example, description will be given of a process of a case in which data of an electronic device 200 which is provided with a wiring pattern 105, an insulating layer 115, pillars 121, and the like which is illustrated in Fig. 13 is input as the three-dimensional data D1. It should be noted that the data conversion device 13 is not limited to the electronic device 200, and is capable of performing the conversion of the three-dimensional data D1 by performing a similar process for devices for which shaping is possible using another additive manufacturing (electrical devices such as a connector in which an electronic component is embedded, wearable devices such as eyeglasses in which an electronic component is embedded, and the like).

The layer information generation section 31 detects members which are included in the three-dimensional data D1 and generates layer information D2 for each of the detected members with respect to the three-dimensional data D1 of the electronic device 200. For example, the layer information generation section 31 generates data for each of the members such as the wiring pattern 105 which are embedded in the electronic device 200 from the three-dimensional data D1 as the layer information D2. The layer information generation section 31 saves the generated layer information D2 in the memory section 25.

The layer data division section 32 reads the layer information D2 which is saved in the memory section 25 and generates layer data D3 in which the members which are included in the layer information D2 are divided into layer thicknesses which can be shaped using the additive manufacturing. Here, data which relates to the materials such as which materials it is possible to manufacture the members such as the wiring pattern 105 is defined in the three-dimensional data D1 which is stored in the server 11 as described above. A metal with conductivity is defined as the material of the wiring pattern 105 of the electronic device 200. Manufacturing apparatus information D4 which relates to the manufacturing apparatus 15 which is described later is saved in the memory section 25. The manufacturing apparatus information D4 referred to here is, for example, information of a material which can be discharged by a first shaping unit 43 with which the manufacturing apparatus 15 is provided, information on the thickness of the layer which is formed corresponding to the droplets of a case in which the material is discharged, and the like. In a case in which droplets of a conductive material are discharged using an inkjet method as the additive manufacturing to perform the shaping, the thickness of the layer which can be shaped in one go is determined according to the size of the droplet of an ink which includes the conductive material to be used, for example, metal nanoparticles (for example, silver). Therefore, the layer data division section 32 determines the correspondence relationship between the data which relates to the materials which are defined in the three-dimensional data D1 and the information of the materials which can be shaped which is set in the manufacturing apparatus information D4. It is preferable for the layer data division section 32 to determine more suitable materials for the data which relates to the material which are defined in the three-dimensional data D1 among the materials which can be shaped which are set in the manufacturing apparatus information D4. The layer data division section 32 generates the layer data D3 by dividing the wiring pattern 105 of the layer information D2 using the maximum layer thickness which can be shaped using the ink which includes the metal nanoparticles, for example. The layer data division section 32 relates the generated layer data D3 with data which relates to the layer information D2 and the materials or the like and saves the related data in the memory section 25.

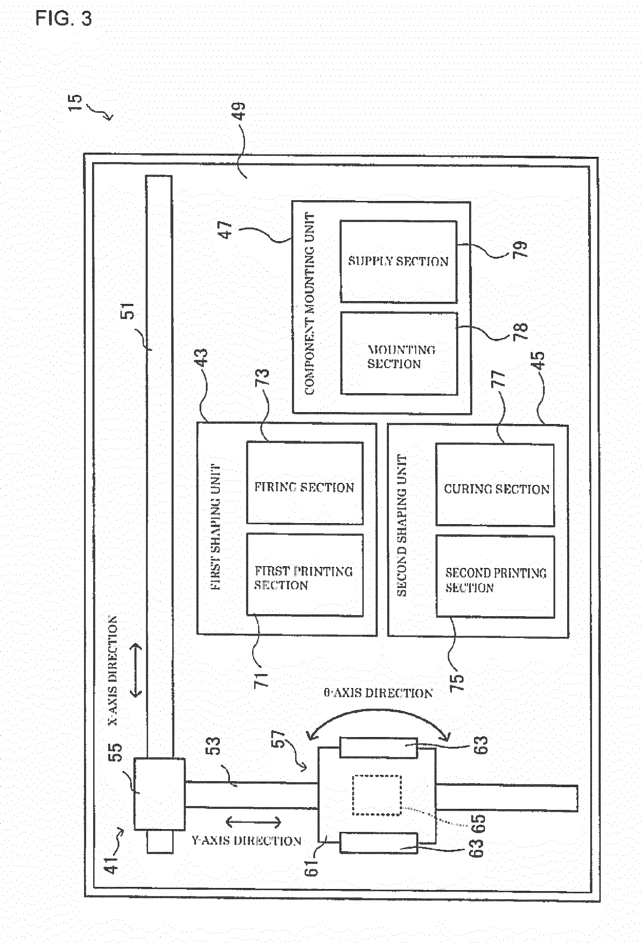

The unit determination section 33 determines the unit which shapes the member based on data or the like which relates to the materials which are related with the layer data D3 which is saved in the memory section 25, for example. The unit determination section 33 associates the discharge unit (the first shaping unit 43 which is illustrated in Fig. 3) which discharges a conductive material as the unit which shapes the wiring pattern 105 which the electronic device 200 includes. The unit determination section 33 saves unit information D5 which relates to the unit which is determined in the memory section 25 in relation to the layer data D3.

The control content determination section 34 generates the control data D6 in which the manner in which to cause the determined unit to operate is set based on the unit information D5 which is saved in the memory section 25 and the layer data D3 which is related to the unit information D5. For example, based on the layer data D3, the shape of the wiring pattern 105 of the electronic device 200 is detected and the control data D6 for causing a stage unit 41 which is described later and the first shaping unit 43 (refer to Fig. 3) to operate in cooperation according to the detected shape of the wiring pattern 105 is generated. The control content determination section 34 saves the generated control data D6 in the memory section 25 in relation to the unit information D5 and the layer data D3.

The first correction section 37 determines whether or not the members which are included in the electronic device 200 can be shaped using the additive manufacturing, and in a case in which it is not possible to perform the manufacturing, performs a process of correcting the shape into a shape which can be shaped. For example, even if the wiring pattern 105 is drawn as curved lines in the three-dimensional data D1, when performing the shaping by discharging droplets of the conductive material using the inkjet method, there is a case in which the distance between the droplets is separated and the wiring does not connect. In a case in which such a wiring pattern 105 is drawn in the three-dimensional data D1, this becomes a cause of electrical connection faults, and the electronic device 200 which is shaped is not longer able to realize the desired function. To handle this, the first correction section 37 determines whether the thickness and curvature of the wiring of the wiring pattern 105 which is detected as the layer information D2 satisfy predetermined conditions, for example. In a case in which the shape and the like of the wiring pattern 105 do not satisfy the conditions, the first correction section 37 first corrects the shape of the wiring pattern 105 to a shape which can be shaped and stores the result in the memory section 25. Due to the layer data division section 32 using the post-correction layer information D2, it is possible to preemptively prevent connection faults and the like of the electronic device 200 to be manufactured. If the first correction section 37 cannot determine whether or not it is possible to shape based on the shape and the like of the members which are included in the electronic device 200, for example, the first correction section 37 may detect, determine, correct, and the like the members directly from the three-dimensional data D1.

The second correction section 38 calculates the electrical characteristics of the electronic device 200 and performs a process of correcting so as to improve the electrical characteristics based on the calculated results. For example, the second correction section 38 determines whether or not the routing of the wiring pattern 105 which connects across an electronic component 125 (refer to Fig. 13) is the shortest distance based on the three-dimensional data D1, and in a case in which the routing of the wiring pattern 105 is not the shortest distance, the shape, position, and the like of the wiring pattern 105 are corrected and the post-correction three-dimensional data D1 is saved in the memory section 25. It is possible to shorten the wiring pattern 105 of the electronic device 200 which is manufactured to reduce the resistance (electrical loss), to reduce the influence of noise from outside, or the like due to the layer information generation section 31 using the post-correction three-dimensional data D1.

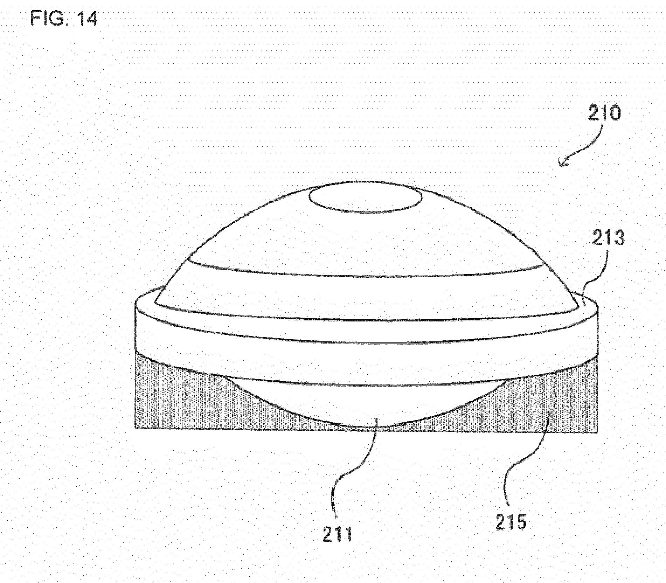

The support material shaping determination section 39 determines whether or not it is necessary to shape the support material which conforms to the external shape of an electronic device 210 (refer to Fig. 14) to be shaped. For example, as in the electronic device 210 which is illustrated in Fig. 14, in a case in which a portion which protrudes toward the outside, a so-called overhang portion or the like is shaped, it becomes necessary to shape the corresponding portion using the support material. The electronic device 210 which is illustrated in Fig. 14 is shaped such that a bottom portion 211 which is formed in a semispherical shape protrudes downward. A disc-shaped protruding section 213 which protrudes toward the outside is formed on the top portion of the bottom portion 211. Various electronic components and circuit boards are embedded in the electronic device 210.

In a case in which the electronic device 210 is shaped, as illustrated in Fig. 14, it is necessary to prepare a support material 215 which is formed to conform to the shape of the bottom portion 211 and the protruding section 213. Therefore, the support material shaping determination section 39 detects the external shape of the electronic device 210 to be shaped based on the three-dimensional data D1, and in a case in which a shape for which the support material 215 is necessary, such as the bottom portion 211 and the protruding section 213, is detected, a process is performed in which a unit for shaping the support material 215 and the information for shaping the support material 215 by controlling the operations of the unit are added to the control data D6.

The data conversion device 13 is connected to the manufacturing apparatus 15 via the input and output section 23. The data conversion device 13 reads the control data D6 which is converted from the three-dimensional data D1 using the layer information generation section 31 which is described above from the memory section 25 and outputs the control data D6 to the data conversion device 13 via the input and output section 23. The manufacturing apparatus 15 performs layered shaping of the electronic device 200 based on the control data D6 which is input from the data conversion device 13.

Next, a detailed description will be given of the manufacturing apparatus 15. Fig. 3 illustrates the configuration of the manufacturing apparatus 15. The manufacturing apparatus 15 is provided with the stage unit 41, the first shaping unit 43, a second shaping unit 45, and a component mounting unit 47. In the manufacturing apparatus 15, the units 43, 45, 47 and the like are disposed above a base 49. The shape of the base 49 is a substantially rectangular shape in plan view. In the following description, explanation will be given referring to the longitudinal direction of the base 49 as the X-axis direction, the short direction of the base 49 as the Y-axis direction, a direction which is perpendicular to both the X-axis direction and the Y-axis direction as the Z-axis direction, and a direction which rotates around a straight line along the Z-axis direction as the θ-axis direction.

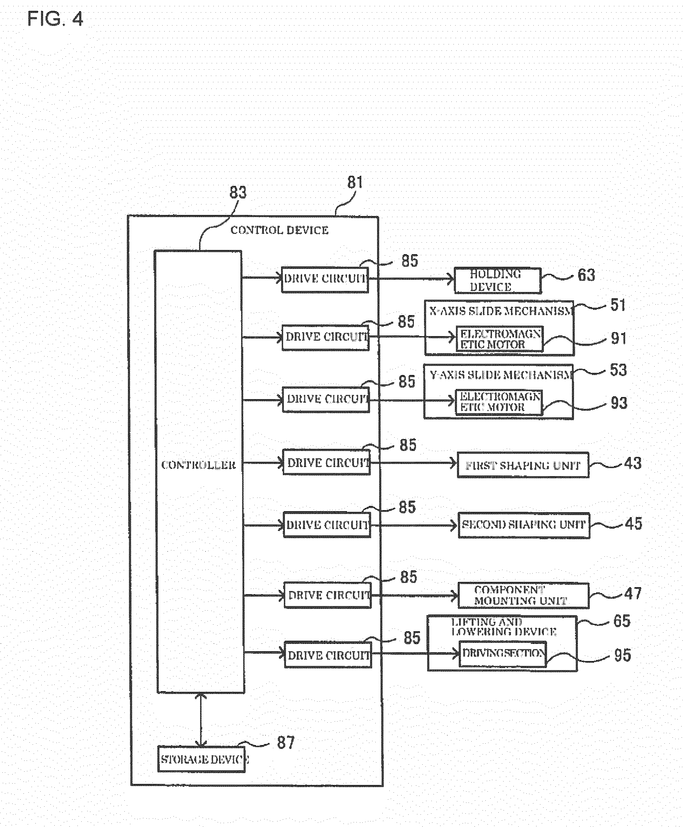

The stage unit 41 includes an X-axis slide mechanism 51 which extends in the X-axis direction and a Y-axis slide mechanism 53 which extends in the Y-axis direction. The X-axis slide mechanism 51 is held by the base 49 and an X-axis slider 55 is provided to be capable of moving in the X-axis direction. In the X-axis slide mechanism 51, the X-axis slider 55 moves to an arbitrary position in the X-axis direction according to the driving of an electromagnetic motor 91 (refer to Fig. 4). In the Y-axis slide mechanism 53, one end portion in the Y-axis direction is held by the X-axis slider 55 and a stage 57 is provided to be capable of moving in the Y-axis direction. In the Y-axis slide mechanism 53, the stage 57 moves to an arbitrary position in the Y-axis direction according to the driving of an electromagnetic motor 93 (refer to Fig. 4). Accordingly, the stage 57 is capable of moving to an arbitrary position on the base 49 due to the X-axis slide mechanism 51 and the Y-axis slide mechanism 53 driving.

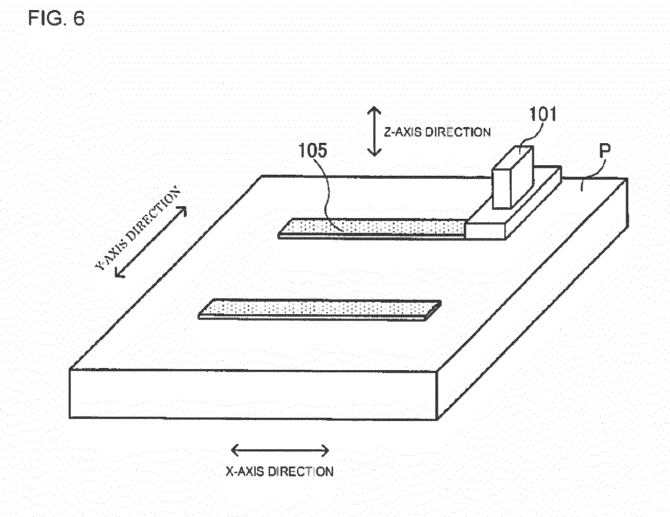

The stage 57 includes a base 61 and a holding device 63. The base 61 is formed in a flat plate shape and a shaping plate P (refer to Fig. 6) is placed on the upper face. The holding device 63 is provided on both sides in the X-axis direction of the base 61. The stage 57 holds the shaping plate P in a fixed manner at a predetermined position by interposing the end portion of the X-axis direction of the shaping plate P which is mounted on the base 61 between the base 61 and the holding device 63. The X-axis direction and the Y-axis direction are directions which are parallel to the surface on which the shaping plate P of the base 61 is placed and are perpendicular to each other.

The stage unit 41 includes a lifting and lowering device 65 which lifts and lowers the base 61 together with the shaping plate P in the Z-axis direction. The lifting and lowering device 65 lifts or lowers the base 61 according to the driving of a driving section 95 (refer to Fig. 4) to change the position of the shaping plate P in the Z-axis direction. The driving section 95 is provided with an air cylinder, for example, as the driving source which causes the base 61 to be lifted and lowered. The lifting and lowering device 65 rotates the base 61 in the θ-axis direction according to the driving of the driving section 95. The driving section 95 is provided with an electromagnetic motor, for example, as the driving source which rotates the base 61 in the θ-axis direction. The lifting and lowering device 65 moves integrally with the stage 57 to an arbitrary position on the base 49.

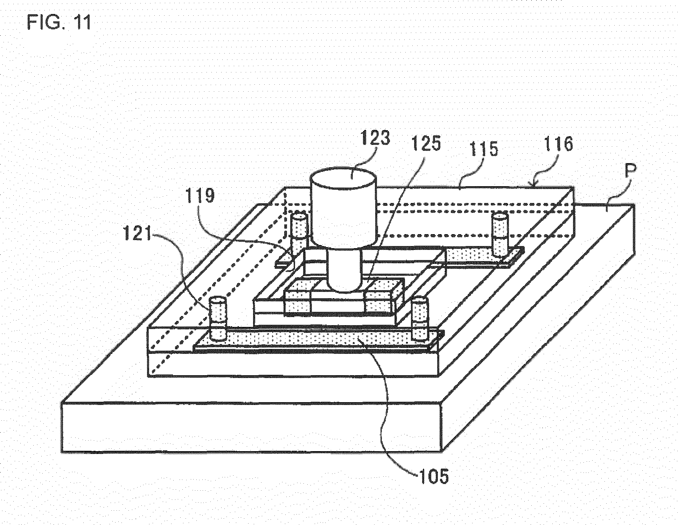

The three units 43, 45, 47, the first shaping unit 43, the second shaping unit 45, and the component mounting unit 47 are provided on the top (the close side in the Z-axis direction of Fig. 3) of the base 49. The manufacturing apparatus 15 is configured such that the units 43, 45, 47 can be attached and detached to a connecting section (not illustrated) which is provided on the top portion of the apparatus. For example, as a connecting section, the manufacturing apparatus 15 is provided with multiple common connectors to which the units 43, 45, 47 can be connected, and a holding mechanism which holds the units 43, 45, 47 which are connected to the connectors. Therefore, in the manufacturing apparatus 15, it is possible to provide more or remove various units according to the type or the like of the electronic device 200 (refer to Fig. 13) to be manufactured. The units 43, 45, 47 perform various work such as shaping the three-dimensional shaped articles on the shaping plate P from above the stage 57 and the shaping plate P, and mounting the electronic component 125 (refer to Fig. 11).

The first shaping unit 43 is, for example, a unit for shaping the wiring pattern 105 and pillars 121 and 129 of the electronic device 200 (refer to Fig. 13), and is provided with a first printing section 71 and a firing section 73. For example, the first printing section 71 drives an inkjet head 101 (refer to Fig. 6) to discharge a conductive material onto the shaping plate P. The conductive material is, for example, an ink which includes metal nanoparticles (for example, silver). For example, the inkjet head 101 discharges the conductive material from multiple nozzles which are provided to line up in the Y-axis direction using a piezo system which uses piezoelectric elements. Information such as the function of the first printing section 71, the material to be used, and the size of the droplets is saved in the memory section 25 as the manufacturing apparatus information D4 (refer to Fig. 2).

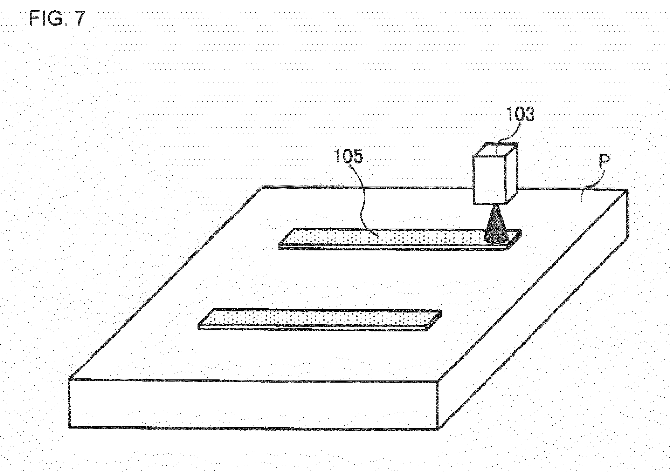

The firing section 73 irradiates the conductive material which is discharged onto the shaping plate P with laser light from an irradiation section 103 (refer to Fig. 7) to perform the sintering. For example, when the shaping plate P moves to a position under the first printing section 71 together with the movement of the stage 57, the first shaping unit 43 discharges the conductive material onto the shaping plate P using the inkjet head 101 and sinters the discharged conductive material using the irradiation section 103 to form the wiring pattern 105 and the pillars 121 and 129.

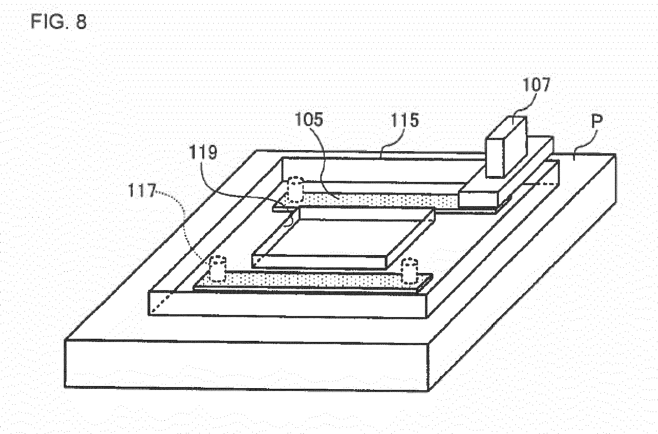

The second shaping unit 45 is, for example, a unit for shaping the insulating layer 115 (refer to Fig. 13) of the electronic device 200 and the support material 215 which is illustrated in Fig. 14, and is provided with a second printing section 75 and a curing section 77. For example, the second printing section 75 drives an inkjet head 107 (refer to Fig. 8) to discharge a UV curable resin onto the shaping plate P. For example, the UV curable resin includes a resin which shapes the insulating layer 115 and a resin which shapes the support material 215 (a resin which melts in a specific solution, or the like). For example, the second shaping unit 45 switches the nozzles of the inkjet head 107 according to the type of resin to be used to shape the insulating layer 115 and the support material 215. For example, the inkjet head 107 may be a piezo system which uses piezoelectric elements and may be a thermal system which heats the resin and generates bubbles to discharge the resin from the nozzle ports.

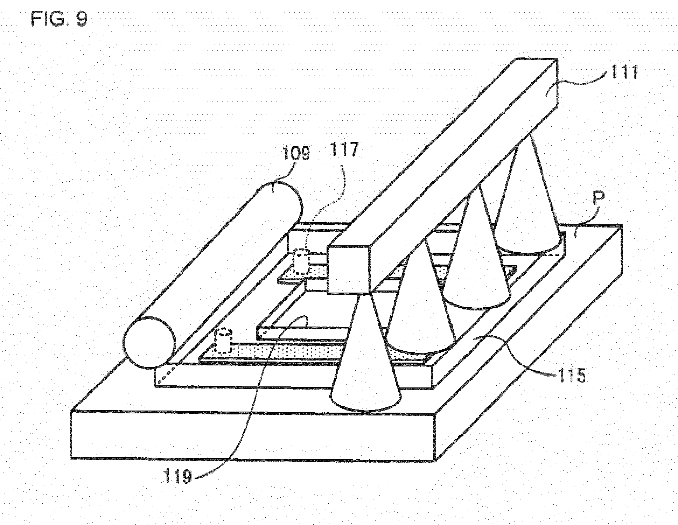

The curing section 77 is provided with a smoothing roller section 109 (refer to Fig. 9) which smoothes the upper face of one or multiple layers of UV curable resin which is discharged onto the shaping plate P by the inkjet head 107. The smoothing roller section 109 scrapes off and collects excess resin while rendering the surface of the UV curable resin uniform using a roller or a blade (not illustrated), for example, and thus maintains the layers at a uniform thickness.

The curing section 77 is provided with a light emitting section 111 (refer to Fig. 9) which radiates ultraviolet rays downward. The light emitting section 111 is provided with a mercury lamp or an LED as a light source, for example. The curing section 77 drives the light emitting section 111 to irradiate and cure the UV curable resin which is discharged onto the shaping plate P. For example, when the shaping plate P moves to a position under the second printing section 75 together with the movement of the stage 57, the second shaping unit 45 discharges the UV curable resin onto the shaping plate P using the inkjet head 107 and cures the discharged UV curable resin using the curing section 77 to shape the insulating layer 115.

The component mounting unit 47 is a unit which mounts various electronic components 125 (refer to Fig. 11) which are connected to the wiring pattern 105 and the pillars 121 and 129 which are shaped by the first shaping unit 43 and is provided with a mounting section 78 and a supply section 79. The mounting section 78 includes a mounting head which holds the electronic component 125 using a suction nozzle 123 (refer to Fig. 11). The mounting section 78 includes a nozzle lifting and lowering device which lifts and lowers the suction nozzle 123 and a nozzle rotation device which causes the suction nozzle 123 to rotate around its own axis, and it is possible to change the position in the Z-axis direction of the electronic component 125 which is held by the suction nozzle 123 and to change the holding posture of the electronic component 125. The mounting section 78 may be provided with a camera for imaging the wiring pattern 105, the pillars 121, and the like to recognize the mounting position, and a camera for imaging the electronic component 125 to recognize the position of the component.

For example, the supply section 79 includes a plurality of tape feeders which feed out the electronic components 125 which are taped one at a time, and the supply section 79 supplies the electronic component 125 to the mounting section 78. The supply section 79 is not limited to a tape feeder and may be a tray-type supply device in which the electronic component 125 is picked up from a tray. The supply section 79 may be configured to include both the tape type and the tray type, or alternatively another supply device. For example, when the shaping plate P moves to a position under the mounting section 78 together with the movement of the stage 57, the component mounting unit 47 moves the mounting head of the mounting section 78 to a component supply position of the supply section 79 and drives the supply section 79 to supply the necessary component. The mounting section 78 mounts the electronic component 125 which is sucked and held by the suction nozzle 123 of the mounting head from the supply position of the supply section 79 to, for example, a position at which the pillars 121 of the workpiece which are formed on the shaping plate P are shaped, or to a location corresponding to the position in which the pillars 121 are planned to be shaped.

In the three units 43, 45, 47 which are described above, the working position of each of the units 43, 45, 47 is fixed in the Z-axis direction and is positioned in the same planar shape parallel to the X-axis direction and the Y-axis direction. More specifically, for example, the nozzle port of the inkjet head 101 of the first shaping unit 43 and the nozzle port of the inkjet head 107 of the second shaping unit 45 are positioned in the same position in the Z-axis direction and are fixed. In other words, in a state in which the stage 57 does not move in the Z-axis direction, the inkjet heads 101 and 107 are at the same distance from the stage 57 (the three-dimensional shaped article to be shaped) in the Z-axis direction. Similarly, for example, a position (a working position) when the droplet of the conductive material which is discharged from the inkjet head 101 hits the workpiece which is being shaped on the stage 57 and a position (a working position) when the mounting head of the mounting section 78 mounts the electronic component 125 sucked by the suction nozzle 123 on the workpiece are the same position in the Z-axis direction Accordingly, in the manufacturing apparatus 15 of the present example, in a case in which the stage 57 moves between the units 43, 45, 47, the adjustment amount by which to positionally adjust the stage 57 with respect to the Z-axis direction is extremely little or is unnecessary.

As illustrated in Fig. 4, the manufacturing apparatus 15 is provided with a control device 81 which performs overall control of the entirety of the manufacturing apparatus 15. The control device 81 is provided with a controller 83 and multiple drive circuits 85. The controller 83 is provided with a CPU, a ROM, a RAM, and the like, the main constituent of the controller 83 is a computer, and the controller 83 is connected to the multiple drive circuits 85. The control device 81 includes a storage device 87 for saving the control data D6 which is received from the data conversion device 13 which is illustrated in Fig. 1. The storage device 87 is an optical drive device such as a hard disk device, for example. The control data D6, for example, is control data for controlling the stage unit 41 and the units 43, 45, 47 according to a working process of the electronic device 200 to be manufactured. More specifically, the control data D6 is, for example, data including multiple layers of cross-sectional shaped shaping data which is obtained by slicing the insulating layer 115 of the electronic device 200 at a predetermined thickness, and positional information (a recipe or the like) for mounting the electronic component 125 on the shaped insulating layer 115. The multiple drive circuits 85 are connected to the holding device 63, the electromagnetic motors 91 and 93, the driving section 95, the units 43, 45, 47, and the like, respectively. The controller 83 controls the operations of the holding device 63 and the like via the drive circuits 85 based on the control data D6, for example. The controller 83 sequentially moves the stage 57 to any of the working positions of the first shaping unit 43, the second shaping unit 45, and the component mounting unit 47 according to the working process which is based on the control data D6 to manufacture the electronic device 200 on the shaping plate P.

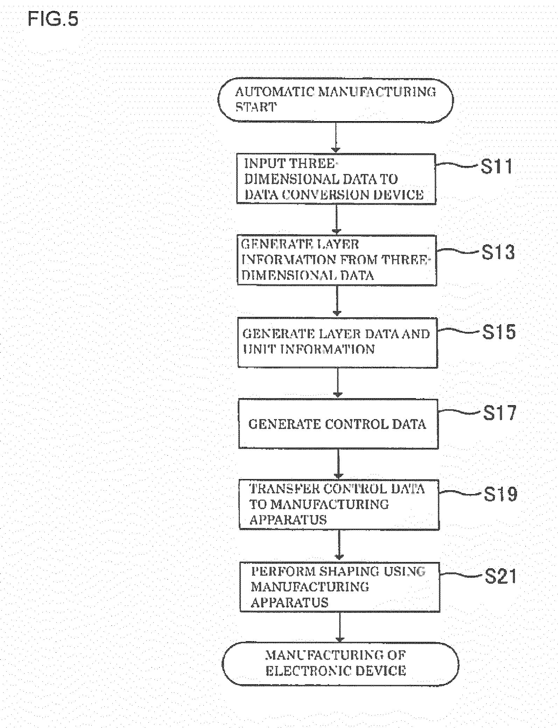

Next, description will be given of an example of the process up to the point at which the electronic device is manufactured from the three-dimensional data D1 according to the flowchart of Fig. 5. According to the configuration which is described above, in the system 10 of the present example, the data conversion device 13 converts the three-dimensional data D1 of the electronic device 200 which is illustrated in Fig. 13 into the control data D6, for example, and the manufacturing apparatus 15 performs the shaping by dividing the electronic device 200 into multiple layers based on the post-conversion control data D6 to sequentially laminate the layers onto the shaping plate P.

More specifically, first, in step (hereinafter denoted as the unit "S") 11 of Fig. 5, the three-dimensional data D1 of the electronic device 200 is input from the server 11 to the data conversion device 13. For example, due to the user selecting the desired data from among the multiple items of three-dimensional data D1 which are stored in the server 11 from on a screen by operating a keyboard or the like of the data conversion device 13, the three-dimensional data D1 is transferred from the server 11 to the data conversion device 13.

Next, in S13, the layer information generation section 31 (refer to Fig. 2) of the data conversion device 13 generates the layer information D2 from the three-dimensional data D1 which is input. For example, the layer information generation section 31 detects members (the wiring pattern 105 and the like) which are included in each of the layers while dividing the three-dimensional data D1 into multiple layers from the bottom side (the shaping plate P side) of the electronic device 200 which is illustrated in Fig. 13. The layer information generation section 31 detects the wiring pattern 105, the insulating layer 115, and the electronic component 125 as members of the bottommost side of the electronic device 200 based on the three-dimensional data D1. Similarly, the layer information generation section 31 detects the members while slicing the electronic device 200 in order from the bottom side to the top side in Fig. 13.

For example, which of the members, among the members which are detected in the same sliced layer, is to be shaped preferentially and the like are set in the layer information generation section 31. In a case in which the layer information generation section 31 detects the wiring pattern 105 and the insulating layer 115 in the same layer, for example, the layer information generation section 31 determines that the wiring pattern 105 is to be shaped before the insulating layer 115. As illustrated in Fig. 13, for example, when the layer information generation section 31 detects that the pillars 129 which are connected to the electronic component 125 are connected to the terminals of the top portion of the electronic component 125, the layer information generation section 31 determines that the insulating layer 115 is to be shaped before performing the mounting of the electronic component 125, and the electronic component 125 is to be buried in the insulating layer 115 which is shaped. In other words, the layer information generation section 31 determines that the insulating layer 115 is to be shaped before the mounting of the electronic component 125. In this manner, the layer information generation section 31 determines the order in which to perform shaping while detecting the members which are included in the electronic device 200 based on the structure and the like thereof and sets the order in which to perform the shaping in the layer information generation section 31.

Next, in S15, the layer data division section 32 generates the layer data D3 in which the members from the layer information D2 are separated into multiple layers, taking into consideration the conditions of the shaping capability of the first shaping unit 43 based on the manufacturing apparatus information D4 of the manufacturing apparatus 15. The unit determination section 33 determines the unit which shapes the member based on the layer data D3 and the information which is related to the layer data D3 to generate the unit information D5.

Next, in S17, the control content determination section 34 generates the control data D6 for operating the unit (the first shaping unit 43 or the like) which is used in the shaping based on the layer data D3 and the unit information D5. The data conversion device 13 transfers the control data D6 which is generated by the control content determination section 34 to the manufacturing apparatus 15 (S19). The first correction section 37, the second correction section 38, and the support material shaping determination section 39 operate before the process of S13 which is described above, for example, or in parallel to the processes S13 to S17 and determine the presence or absence of correction of the three-dimensional data D1 and the necessity of the support material shaping determination section 39.

Next, in S21, the manufacturing apparatus 15 performs the shaping of the electronic device 200 based on the control data D6 which is input from the data conversion device 13. Description will be given of the specific shaping process of the manufacturing apparatus 15 with reference to Figs. 6 to 13. The controller 83 (refer to Fig. 4) of the manufacturing apparatus 15 saves the control data D6 which is received from the data conversion device 13 in the storage device 87. First, of the members of the bottommost layer, the controller 83 performs the shaping of the wiring pattern 105 which is set to have the highest priority based on the control data D6. The controller 83 controls the X-axis slide mechanism 51 and the Y-axis slide mechanism 53 of the stage unit 41, carries in the stage 57 (refer to Fig. 3) on which the shaping plate P which is illustrated in Fig. 6 is set to the first shaping unit 43, and moves the stage 57 to the bottom portion of the inkjet head 101 which is at the working position of the first printing section 71. The controller 83 controls the first shaping unit 43 based on the data of the first layer which is set in the control data D6 and discharges the conductive material from the inkjet head 101 onto the shaping plate P. A film of the conductive material which is formed by multiple droplets is formed on the shaping plate P. How the first shaping unit 43 and the stage unit 41 are operated, for example, and the positions of the shaping plate P in the X-axis direction and the Y-axis direction are determined by the control content determination section 34.

The controller 83 controls the firing section 73, and as illustrated in Fig. 7, the film of the conductive material which is discharged by the inkjet head 101 is irradiated with laser light from the irradiation section 103 to locally heat and fire the film. Accordingly, a first layer cross-sectional shape is formed on the shaping plate P. The laser light source of the firing section 73 is, for example, a semiconductor laser, a carbon dioxide laser, a YAG laser, or the like. The controller 83 carries out the work illustrated in Figs. 6 and 7 once or multiple times to shape the desired wiring pattern 105 on the shaping plate P.

The control content determination section 34 may generate the control data D6 in which, first, multiple layers are printed using the inkjet head 101, for example, according to the capabilities of the inkjet head 101 and the irradiation section 103, and the multiple layers are fired in one go by the irradiation section 103. For example, the control content determination section 34 may generate the control data D6 in which if it is possible to perform the heating process using the irradiation section 103 in parallel with the discharging by the inkjet head 101, parallel processing is performed.

The controller 83 carries out the work of the first shaping unit 43 while moving the stage 57 together with the shaping plate P in the X-axis direction, the Y-axis direction, and the Z-axis direction. In the manufacturing apparatus 15 of the present example, since the stage 57 is the subject of the movement, the positions of the inkjet head 101 of the first shaping unit 43 and the irradiation section 103 (in the X-axis direction and the like) are fixed. The information which relates to the manufacturing apparatus 15 is saved in the memory section 25 of the data conversion device 13 as the manufacturing apparatus information D4. Therefore, the control content determination section 34 determines the position to which the shaping plate P will be moved by the stage unit 41 relative to the inkjet head 101, the irradiation section 103, and the like based on the manufacturing apparatus information D4 and sets the control data D6.

Next, as illustrated in Fig. 8, the controller 83 controls the X-axis slide mechanism 51 and the Y-axis slide mechanism 53, carries in the shaping plate P and the stage 57 to the second shaping unit 45, and moves the shaping plate P and the stage 57 to the bottom portion of the inkjet head 107 which is the working position of the second printing section 75. The controller 83 controls the second shaping unit 45 based on the control data D6 and discharges the ultraviolet curing material which has insulating properties from the inkjet head 107 onto the shaping plate P.

The controller 83 controls the curing section 77 and, as illustrated in Fig. 9, smoothes the surface of the film of the layered UV curable resin which is formed on the shaping plate P using the smoothing roller section 109. The smoothing roller section 109 performs the smoothing of the surface of the workpiece and the collection of the excess UV curable resin due to the stage 57 moving in the X-axis direction in a state in which, for example, the stage 57 is pressed onto the surface of the layered workpiece (the three-dimensional shaped article). Therefore, for example, the control content determination section 34 determines which stage of the shaping of the layered workpiece at which to operate the smoothing roller section 109, that is, determines the operation timing of the smoothing roller section 109 and sets the result in the control data D6. The control content determination section 34 determines the position and the orientation at which to move the shaping plate P with respect to the smoothing roller section 109 which is to operate based on the layer data D3, for example, and sets the results in the control data D6 as data for controlling the stage unit 41.

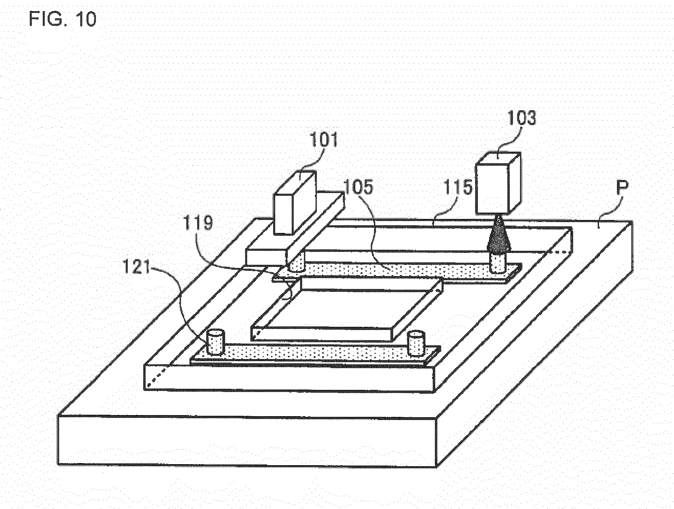

The controller 83 controls the curing section 77 such that the UV curable resin which is discharged by the inkjet head 107 is irradiated with ultraviolet rays from the light emitting section 111. The second shaping unit 45 repeatedly performs the series of processes of the discharging by the inkjet head 107, the smoothing by the smoothing roller section 109, and the curing by the light emitting section 111 and shapes the insulating layer 115 on the wiring pattern 105. Through-holes 117 for forming the pillars 121 (refer to Fig. 10) are shaped in the insulating layer 115 aligned to the position of the wiring pattern 105. A recessed portion 119 for burying the electronic component 125 is shaped in approximately the center portion of the insulating layer 115. Therefore, the control content determination section 34 sets data such as how many times the first shaping unit 43 is to repeat the series of processes of the discharging, the smoothing, and the curing, for example, in the control data D6. The control content determination section 34 determines the positions and the like at which the UV curable resin is not to be discharged aligned with the positions of the through-holes 117, for example, in the control data D6.

Next, as illustrated in Fig. 10, the controller 83 carries in the stage 57 to the first shaping unit 43 again. The controller 83 controls the first shaping unit 43 and discharges the conductive material from the inkjet head 101 into the through-holes 117. The controller 83 controls the firing section 73 to irradiate and fire the conductive material inside the through-holes 117 with laser light from the irradiation section 103. The controller 83 carries out the heating process by the irradiation section 103 in parallel with the discharging by the inkjet head 107, for example. The controller 83 repeatedly performs the discharging by the inkjet head 101 and the firing by the irradiation section 103. The pillars 121 which are connected to the wiring pattern 105 and penetrate in the Z-axis direction are shaped in the insulating layer 115. The controller 83 controls the first shaping unit 43 and the second shaping unit 45 to repeatedly perform the processes of Fig. 6 to Fig. 10 which are described above and, for example, shapes a multilayer wiring board 116 in which the insulating layer 115 in which the wiring pattern 105 and the pillars 121 which are illustrated in Fig. 11 are formed is laminated.

Next, the controller 83 carries in the stage 57 to the component mounting unit 47. As illustrated in Fig. 11, the controller 83 controls the component mounting unit 47 to mount the electronic component 125 which is supplied from the supply section 79 of the mounting section 78 to the suction nozzle 123 of the mounting head inside the recessed portion 119. In the suction nozzle 123, negative pressure air or positive pressure air is supplied from a positive and negative pressure supply device (not illustrated), for example. The suction nozzle 123 has a structure in which the electronic component 125 is sucked and held using a negative pressure and the held electronic component 125 is released by a minute positive pressure being supplied. The controller 83 controls the component mounting unit 47 to adjust the position of the suction nozzle 123, the orientation of the electronic component 125, and the like and mount the electronic component 125 inside the recessed portion 119. Therefore, the control content determination section 34 sets information of the supply section 79 in which the suction nozzle 123 acquires the electronic component 125, information of the position at which to mount the sucked electronic component 125, the orientation of the electronic component 125 to be mounted, and the like in the control data D6.

In the present example, the stage 57 illustrated in Fig. 3 is provided with the lifting and lowering device 65 which rotates the base 61 in the θ-axis direction. Therefore, in a case in which the manufacturing apparatus 15 rotates the stage 57 (the shaping plate P) using the lifting and lowering device 65, adjusts the orientation of the electronic component 125 with respect to the multilayer wiring board 116, and the like, a nozzle rotation device or the like may not be provided on the suction nozzle 123. In this case, for example, information that the manufacturing apparatus 15 has a function capable of adjusting the orientation of the electronic component 125 by rotating the stage 57 is set in the manufacturing apparatus information D4 of the memory section 25 (refer to Fig. 2). Accordingly, the control content determination section 34 becomes capable of setting the rotational direction, the rotational position, and the like of the lifting and lowering device 65 in the control data D6 based on the information of the manufacturing apparatus information D4.

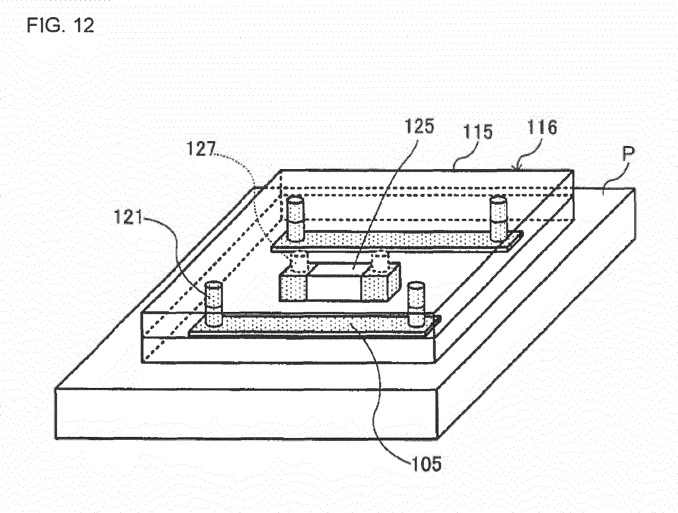

Next, the controller 83 carries in the stage 57 to the second shaping unit 45 again. The controller 83 controls the second shaping unit 45 based on the control data D6 to repeatedly perform the series of processes of the discharging of the UV curable resin by the inkjet head 107, the smoothing by the smoothing roller section 109, and the curing of the UV curable resin by the light emitting section 111 and buries the electronic component 125 in the recessed portion 119. As illustrated in Fig. 12, through-holes 127 are formed in the multilayer wiring board 116 to be aligned to the positions of the connection terminals of the electronic component 125.

Next, the controller 83 carries in the stage 57 to the first shaping unit 43 again. The controller 83 controls the first shaping unit 43 and discharges the conductive material from the inkjet head 101 into the through-holes 127. The controller 83 controls the firing section 73 to irradiate and fire the conductive material inside the through-holes 127 with laser light from the irradiation section 103. The controller 83 repeatedly performs the discharging by the inkjet head 101 and the firing by the irradiation section 103. As illustrated in Fig. 13, the pillars 129 which are connected to the connection terminals of the electronic component 125 and penetrate in the Z-axis direction are shaped in the multilayer wiring board 116. In this manner, the manufacturing apparatus 15 becomes capable of controlling the units 41, 43, 45, and 47 based on the control data D6 which is input from the data conversion device 13 and manufacturing the electronic device 200 on the shaping plate P.

Incidentally, in the example described above, the electronic devices 200 and 210 are examples of electrical devices. The wiring pattern 105, the insulating layer 115, the pillars 121 and 129, and the like are examples of members which are included in the three-dimensional data. The first shaping unit 43 is an example of a discharge unit and a firing unit. The second shaping unit 45 is an example of the discharge unit and a curing unit. The component mounting unit 47 is an example of a mounting unit.

Hereinabove, the present example which is described above has the following effects.

<Effect 1> When the three-dimensional data D1 of the electronic device 200 is input to the data conversion device 13, the data conversion device 13 uses the layer information generation section 31 and the like to automatically generate the control data D6 which is necessary for the manufacturing apparatus 15 to shape the electronic device 200. Therefore, for example, the user becomes capable of acquiring the necessary data (the control data D6) for the layered shaping merely by setting the three-dimensional data D1 and inputting the three-dimensional data D1 to the data conversion device 13. Accordingly, it becomes possible to obtain a reduction in the number of workers necessary in the manufacturing process of the electronic device 200 and a shortening of the time necessary for the manufacturing.

<Effect 2> The first correction section 37 determines whether or not it is possible to shape the members which are included in the electronic device 200 using the additive manufacturing, and in a case in which it is not possible to perform the manufacturing, corrects the members to shapes which can be shaped. In a case in which the thickness and curvature of the wiring of the wiring pattern 105 which is detected as the layer information D2 do not satisfy the predetermined conditions, for example, the first correction section 37 corrects the wiring to a shape which can be shaped. Accordingly, it becomes possible to preemptively prevent connection faults and the like of the electronic device 200 to be manufactured.

<Effect 3> The second correction section 38 determines whether or not the routing of the wiring pattern 105 which connects across an electronic component 125 is the shortest distance based on the three-dimensional data D1, and in a case in which the routing of the wiring pattern 105 is not the shortest distance, the shape and the like of the wiring pattern 105 are corrected. Accordingly, it becomes possible to shorten the wiring pattern 105 of the electronic device 200 which is manufactured to reduce the resistance (electrical loss) or the like.

<Effect 4> In a case in which the electronic device 210 illustrated in Fig. 14 is to be shaped, the support material shaping determination section 39 detects the external shape of the electronic device 210 based on the three-dimensional data D1, and in a case in which a shape for which the support material 215 is necessary, such as the bottom portion 211 and the protruding section 213, is detected, a process is performed in which a unit for shaping the support material 215 and the information for shaping the support material 215 by controlling the operations of the unit are added to the control data D6. Accordingly, the data conversion device 13 becomes capable of automatically determining whether or not it is necessary to add a process of shaping the support material 215 or the like based on the three-dimensional data D1 of the electronic device 210.

The present invention is not limited to the example described above, and it is possible to embody the present invention in various modes subjected to various modifications and improvements based on the knowledge of a person skilled in the art. For example, in the example described above, the three-dimensional data D1 is not limited to data which is designed using CAD, and may be data which is designed using another tool which can be used to design three-dimensional objects. In the example which is described above, the manufacturing apparatus 15 performs the shaping of the electronic device 200 based on the control data D6 which is converted by the data conversion device 13; however, a configuration may be adopted in which the manufacturing apparatus 15 performs the shaping using other intermediate data. In the example which is described above, the manufacturing apparatus 15 may be configured to include a unit with a different function from the three units 43, 45, 47. For example, the manufacturing apparatus 15 may be configured to include a unit for burying a comparatively large hole such as the recessed portion 119 or the like with a UV curable resin in the example which is described above, more specifically, a dispenser or the like which has a large discharge amount in
comparison to the inkjet head 107 of the second printing section 75. Alternatively, the manufacturing apparatus 15 may include a unit for adhering and fixing the electronic component 125 or the like to the insulating layer 115.

In the example described above, the method of performing layered shaping on the multilayer wiring board 116 is not limited to a droplet discharging method such as the inkjet method, and may be a method in which a powder material is laid in layers and the powder material is bonded with a binder to perform the shaping. Alternatively, a method may be adopted in which a powder material is laid in layers, and is irradiated with laser light to perform the firing and shaping. The disposition of the units 43, 45, 47 in the example described above is an example, and may be changed as appropriate. For example, a configuration may be adopted in which the units 43, 45, 47 are disposed on a straight line along the X-axis direction.

### Reference Signs List

10: additive manufacturing system, 13: data conversion device, 15: manufacturing apparatus, 31: layer information generation section, 32: layer data division section, 33: unit determination section, 34: control content determination section, 37: first correction section, 38: second correction section, 39: support material shaping determination section, 41, 43, 45, 47: unit, 200, 210: electronic device, 215: support material, D1: three-dimensional data, D2: layer information, D3: layer data, D4: manufacturing apparatus information, D5: unit information, D6: control data.

## Claims

1. An additive manufacturing system (10) which is configured to shape an electrical device using an additive manufacturing based on data which is configured to be converted by a data conversion device (13), said data being three-dimensional data (D1) of the electrical device, comprising the shape, material and position of members with which the electronic device is provided, wherein the additive manufacturing system (10) comprises
at least one of a plurality of units for shaping the members including units of
a stage unit which is configured to move with a layered workpiece which is shaped being placed on a stage,
a discharge unit which is configured to discharge either a conductive material or an insulating material onto the stage to shape a layered workpiece,
a firing unit which is configured to fire the conductive material which is discharged onto the stage by the discharge unit to shape a wiring pattern,
a curing unit which is configured to cure the insulating material which is discharged onto the stage by the discharge unit to shape an insulating layer, and
a mounting unit which is configured to mount an electronic component onto the layered workpiece;
**characterized in that** the data conversion device (13) comprises:
a layer information (D2) generation section (31) which, with respect to the three-dimensional data (D1) of the electrical device, is configured to detect the members which are included in the three-dimensional data (D1) and configured to generate layer information (D2) for each of the detected members;
a layer data division section (32) which is configured to generate layer data (D3) in which the members which are included in the layer information (D2) are divided into layer thicknesses which can be shaped using materials using an additive manufacturing based on information of the materials of the members which are included in the three-dimensional data (D1);
a unit determination section (33) which is configured to determine a unit among said units for shaping the members based on the layer data (D3);
a control content determination section (34) which is configured to generate control data (D6) for operating the unit which is determined by the unit determination section (33) according to a shape of the layer data (D3); wherein
the detected members include a wiring pattern (105) and/or an insulating layer.

2. The additive manufacturing system (10) according to Claim 1, further comprising:
a first correction section which is configured to determine whether or not the members can be shaped using an additive manufacturing based on thickness or curvature of the members which is included in the three-dimensional data (D1), and in a case in which the members cannot be shaped, is configured to correct the members to a shape which can be shaped.

3. The additive manufacturing system (10) according to Claim 1 or 2, further comprising:
a second correction section which is configured to calculate electrical characteristics of the electrical device based on the three-dimensional data (D1) and is configured to correct the three-dimensional data (D1) so as to improve the electrical characteristics based on a result of the calculation by changing the shape or position the wiring pattern (105) or insulating layer.

4. The additive manufacturing system (10) according to any of Claims 1 to 3, further comprising:
a support material shaping determination section (39) which is configured to detect an external shape of the electrical device based on the three-dimensional data (D1) and is configured to determine whether or not it is necessary to shape a support material which conforms to the external shape of the electrical device.

## Patentansprüche

1. System zur generativen Fertigung (10), das konfiguriert ist eine elektrische Vorrichtung unter Verwendung einer additiven Fertigung auf der Grundlage von Daten zu formen, die konfiguriert sind durch eine Datenumwandlungsvorrichtung (13) umgewandelt zu werden, wobei die Daten dreidimensionale Daten (D1) der elektrischen Vorrichtung sind, die die Form, das Material und die Position von Elementen umfassen, mit denen die elektronische Vorrichtung versehen ist, wobei das System zur generativen Fertigung (10) Folgendes umfasst
mindestens eine aus einer Vielzahl von Einheiten zum Formen der Elemente, einschließlich der Einheiten:
einer Tischeinheit, die konfiguriert ist sich mit einem geschichteten Werkstück, das geformt wird, zu bewegen, das auf einem Tisch platziert ist,
einer Entladeeinheit, die konfiguriert ist entweder ein leitendes Material oder ein isolierendes Material auf den Tisch zu entladen, um ein geschichtetes Werkstück zu formen,
eine Brenneinheit, die konfiguriert ist das leitende Material, das von der Entladeeinheit auf den Tisch entladen wird, zu brennen, um ein Verdrahtungsmuster zu formen,
eine Aushärteeinheit, die konfiguriert ist das isolierende Material auszuhärten, das durch die Entladeeinheit auf den Tisch entladen wird, um eine isolierende Schicht zu formen, und
eine Montageeinheit, die konfiguriert ist ein elektronisches Bauteil auf das geschichtete Werkstück zu montieren;
**dadurch gekennzeichnet, dass** die Datenumwandlungsvorrichtung (13) umfasst:
einen Abschnitt (31) zur Erzeugung von Schichtinformationen (D2), der in Bezug auf die dreidimensionalen Daten (D1) der elektrischen Vorrichtung, konfiguriert ist die Elemente zu erfassen, die in den dreidimensionalen Daten (D1) enthalten sind, und konfiguriert ist Schichtinformationen (D2) für jedes der erfassten Elemente zu erzeugen;
einen Schichtdaten-Teilungsabschnitt (32), der konfiguriert ist, um Schichtdaten (D3) zu erzeugen, in denen die Elemente, die in den Schichtinformationen (D2) enthalten sind, in Schichtdicken unterteilt sind, die unter Verwendung von Materialien bei der additiven Fertigung auf der Grundlage von Informationen über die Materialien der Elemente, die in den dreidimensionalen Daten (D1) enthalten sind, geformt werden können;
einen Einheitsbestimmungsabschnitt (33), der konfiguriert ist eine Einheit unter den Einheiten zur Formung der Elemente auf der Grundlage der Schichtdaten (D3) zu bestimmen;
einen Steuerinhaltsbestimmungsabschnitt (34), der konfiguriert ist, um Steuerdaten (D6) zum Betreiben der Einheit zu erzeugen, die durch den Einheitenbestimmungsabschnitt (33) gemäß einer Form der Schichtdaten (D3) bestimmt wird; wobei
die erfassten Elemente ein Verdrahtungsmuster (105) und/oder eine Isolierschicht umfassen.

2. Das System zur generativen Fertigung (10) gemäß Anspruch 1, des Weiteren umfassend:
einen ersten Korrekturabschnitt, der konfiguriert ist auf der Grundlage der Dicke oder der Krümmung der Elemente, die in den dreidimensionalen Daten (D1) enthalten sind, zu bestimmen, ob die Elemente unter Verwendung einer additiven Fertigung geformt werden können oder nicht, und in einem Fall, in dem die Elemente nicht geformt werden können, konfiguriert ist die Elemente in eine Form zu korrigieren, die geformt werden kann.

3. Das System zur generativen Fertigung (10) gemäß Anspruch 1 oder 2, des Weiteren umfassend:
einen zweiten Korrekturabschnitt, der konfiguriert ist elektrische Eigenschaften der elektrischen Vorrichtung auf der Grundlage der dreidimensionalen Daten (D1) zu berechnen und so konfiguriert die dreidimensionalen Daten (D1) zu korrigieren, um die elektrischen Eigenschaften auf der Grundlage eines Ergebnisses der Berechnung zu verbessern, indem dieser die Form oder die Position des Verdrahtungsmusters (105) oder der Isolierschicht ändert.

4. Das System zur generativen Fertigung (10) gemäß einem der Ansprüche 1 bis 3, des Weiteren umfassend:
einen Abschnitt (39) zur Bestimmung der Form des Trägermaterials, der konfiguriert ist eine äußere Form der elektrischen Vorrichtung auf der Grundlage der dreidimensionalen Daten (D1) zu erfassen und konfiguriert ist zu bestimmen, ob es notwendig ist, ein Trägermaterial zu formen, das mit der äußeren Form der elektrischen Vorrichtung übereinstimmt oder nicht.

## Revendications

1. Système de fabrication additive (10) configuré pour former un dispositif électrique à l'aide d'une fabrication additive sur la base de données qui sont configurées pour être converties par un dispositif de conversion de données (13), lesdites données étant des données tridimensionnelles (D1) du dispositif électrique, comprenant la forme, le matériau et la position d'éléments dont est constitué le dispositif électrique, dans lequel le système de fabrication additive (10) comprend
au moins une unité parmi une pluralité d'unités pour former les éléments, constituée par les unités suivantes :
une unité de plateau configurée pour déplacer une pièce stratifiée qui est formée lorsqu'elle est placée sur un plateau,
une unité de déchargement configurée pour décharger soit un matériau conducteur, soit un matériau isolant sur le plateau pour former une pièce stratifiée,
une unité de cuisson configurée pour cuire le matériau conducteur qui est déchargé sur le plateau par l'unité de déchargement pour former un schéma de câblage,
une unité de durcissement configurée pour durcir le matériau isolant qui est déchargé sur le plateau par l'unité de déchargement pour former une couche isolante, et
une unité de montage configurée pour monter un composant électronique sur la pièce stratifiée ;
**caractérisé en ce que** le dispositif de conversion de données (13) comprend :
une section de génération (31) d'information de couche (D2) qui, par rapport aux données tridimensionnelles (D1) du dispositif électrique, est configurée pour détecter les éléments qui sont inclus dans les données tridimensionnelles (D1) et est configurée pour générer de l'information de couche (D2) pour chacun des éléments détectés ;
une section de division de données de couche (32) configurée pour générer des données de couche (D3), dans laquelle les éléments qui sont inclus dans l'information de couche (D2) sont divisés en épaisseurs de couche qui peuvent être formées en utilisant des matériaux à l'aide d'une fabrication additive sur la base d'information des matériaux des éléments qui sont inclus dans les données tridimensionnelles (D1) ;
une section de détermination d'unité (33) configurée pour déterminer une unité parmi lesdites unités pour former les éléments sur la base des données de couche (D3) ;
une section de détermination de contenu de contrôle (34) configurée pour générer des données de contrôle (D6) afin d'exploiter l'unité qui est déterminée par la section de détermination d'unité (33) conformément à une forme des données de couche (D3) ; dans lequel
les éléments détectés comprennent un schéma de câblage (105) et/ou une couche isolante.

2. Système de fabrication additive (10) selon la revendication 1, comprenant en outre :
une première section de correction configurée pour déterminer si les éléments peuvent ou non être formés à l'aide d'une fabrication additive sur la base de l'épaisseur ou de la courbure des éléments, qui est incluse dans les données tridimensionnelles (D1), et dans le cas où les éléments ne peuvent pas être formés, configurée pour corriger les éléments selon une forme qui peut être formée.

3. Système de fabrication additive (10) selon la revendication 1 ou 2, comprenant en outre :
une deuxième section de correction configurée pour calculer les caractéristiques électriques du dispositif électrique sur la base des données tridimensionnelles (D1), et configurée pour corriger les données tridimensionnelles (D1) de manière à améliorer les caractéristiques électriques sur la base d'un résultat du calcul en changeant la forme ou la position du schéma de câblage (105) ou de la couche isolante.

4. Système de fabrication additive (10) selon l'une quelconque des revendications 1 à 3, comprenant en outre :
une section de détermination de conformation du matériau de support (39) configurée pour détecter une forme externe du dispositif électrique sur la base des données tridimensionnelles (D1) et configurée pour déterminer s'il est nécessaire ou non de former un matériau de support qui se conforme à la forme externe du dispositif électrique.
